# EUROPÄISCHE PATENTSCHRIFT

(11) **EP 0 734 774 B1**
(45) Veröffentlichungstag und Bekanntmachung des Hinweises auf die Patenterteilung: **30.01.2002**
(21) Anmeldenummer: 96104087.0
(22) Anmeldetag: 15.03.1996
(51) Int. Cl.: B03C 3/68

(54) **Verfahren zum Betrieb eines elektrostatischen Abscheiders**
Method for operating an electrostatic precipitator
Méthode pour contrôler une précipitateur électrostatique

(30) Priorität: 30.03.1995 DE 19511442
(43) Veröffentlichungstag der Anmeldung: 02.10.1996
(73) Patentinhaber: BBP Environment GmbH, 51643 Gummersbach (DE)
(72) Erfinder: Keldenich, Kai, Dr., 45134 Essen (DE); Rüben, Wilhelm, 47800 Krefeld (DE); Ruther, Gerd, 45127 Essen (DE); Weirich, Walter, Dr., 47803 Krefeld (DE)
(74) Vertreter: Radünz, Ingo, Dipl.-Ing.

(56) Entgegenhaltungen:
- EP-A- 0 576 069
- DE-C- 4 111 673
- US-A- 3 959 715

## Beschreibung

Die Erfindung betrifft ein Verfahren zum Betrieb eines elektrostatischen Abscheiders gemäß dem Oberbegriff des Anspruchs 1. Elektrostatische Abscheider, im folgenden kurz E-Filter genannt, werden zur Entstaubung von Rauchgasen eingesetzt. Dabei wird der Staub mittels an Sprühelektroden angelegter Hochspannung ionisiert und an Niederschlagselektroden abgeschieden. Da die abgeschiedene Staubmenge mit zunehmender Spannung steigt, werden die E-Filter bei möglichst hohen Spannungen, d.h. bei Spannungen in der Nähe der Durchschlaggrenze, betrieben. Zur Führung der Spannung an der Durchschlaggrenze wird die nach einem Durchschlag abgesenkte Spannung schnell bis in die Nähe der Durchschlagspannung erhöht und auf einem möglichst hohen Wert bis zum nächsten Durchschlag geführt.

Aus "Entstaubung industrieller Gase mit Elektrofiltern", Harry J. White, Seiten 192 und 193, VEB Deutscher Verlag für Grundstoffindustrie, Leipzig 1969 ist es bekannt, daß es zur Erzielung eines maximalen Abscheidegrades eine optimale Anzahl von Durchschlägen pro Zeiteinheit gibt. Es ist weiter bekannt, daß der zeitliche Mittelwert der Spannung in Abhängigkeit von der Anzahl der Durchschläge pro Zeiteinheit ein Maximum hat und die zum Maximum gehörende Anzahl von Durchschlägen pro Zeiteinheit auch das Optimum für den maximalen Abscheidegrad bildet. Demnach wäre es denkbar, einen E-Filter bei einer konstanten optimalen Anzahl von Durchschlägen pro Zeiteinheit, die einer maximalen mittleren Spannung entspricht, zu betreiben. Problematisch dabei ist jedoch, daß sich die Betriebsbedingungen wie Staubgehalt des Rauchgases, Zusammensetzung des Staubes oder Zusammensetzung, Feuchte, Volumenstrom oder Temperatur des Rauchgases je nach Anlage mehr oder weniger stark und mehr oder weniger schnell ändern können. Damit ändert sich auch die optimale Anzahl der Durchschläge pro Zeiteinheit.

Aus der DE-C 41 11 673 ist ein Verfahren zur Bestimmung der optimalen Anzahl von Durchschlägen pro Zeiteinheit in einem elektrostatischen Abscheider beschrieben. Die Bestimmung der optimalen Anzahl von Durchschlägen pro Zeiteinheit erfolgt schrittweise, wobei Spannungswerte bezogen auf Werte von Durchschlagspannungen der einzelnen Schritte miteinander verglichen werden. Nachteil einer schrittweisen Anpassung könnten Schwankungen um den optimalen Wert sein. Ein weiteres Problem dieses Verfahrens ist, daß zur Bestimmung der optimalen Anzahl von Durchschlägen die Durchschlagspannung benötigt wird. Da der Spannungsabfall bei einem Durchschlag sehr schnell ist, ist der Wert der Durchschlagspannung, nämlich der zuletzt gemessene Wert, mit einem größeren Fehler als Spannungswerte vor dem Durchschlag behaftet.

Aus der DE-C 42 20 658 ist ein Verfahren zum Führen der Spannung eines elektrostatischen Abscheiders an der Durchschlaggrenze bekannt. Bei diesem Verfahren wird ausgehend von einer optimalen Anzahl von Durchschlägen die Spannung aufgrund dieser Anzahl an der Durchschlaggrenze geführt und nach einer erneuten Bestimmung der optimalen Anzahl von Durchschlägen die Spannung mit Hilfe dieses neuen Wertes an der Durchschlaggrenze geführt. Bei der Führung der Spannung wird nach einem Durchschlag eine Zielspannung ermittelt, auf die die Spannung angehoben und auf der sie bis zum nächsten Durchschlag gehalten wird. Unabhängig von der Ermittlung der Zielspannung wird überprüft, ob in einem vorgebenen Zeitintervall die der optimalen Anzahl von Durchschlägen entsprechende Anzahl von Durchschlägen stattgefunden hat.

Aufgabe der Erfindung ist es, ein Verfahren zum Betrieb eines elektrostatischen Abscheiders gemaß dem Oberbegriff des Anspruchs 1 zu entwickeln, bei dem die Spannungsführung automatisch an schwankende Betriebsbedingungen angepaßt wird. Die Bestimmung der optimalen Anzahl von Durchschlägen pro Zeiteinheit sollte möglichst ohne oder nur mit geringem Einfluß der Durchschlagspannung erfolgen.

Durch die Zyklen aus erster und zweiter Stufe, d.h. aus Ermittlung der optimalen Anzahl von Durchschlägen pro Zeiteinheit nₒₚₜ und aus Regelung auf diese, wird eine automatische Anpassung des Spannungsverlaufs an sich ändernde Betriebsbedingungen durchgeführt.

Zur Ermittlung der optimalen Anzahl von Durchschlägen nₒₚₜ wird der Spannungsverlauf in aufeinander folgenden Ermittlungsschritten auf verschiedene, vorgegebene Anzahlen von Durchschlägen pro Zeiteinheit nₛ geregelt. Dabei wird jeweils die tatsächliche Anzahl von Durchschlägen pro Zeiteinheit nᵢ und die mittlere Spannung U gemessen. In dem sich anschließenden Bestimmungsschritt wird aus diesen Meßwerten die zur maximalen mittleren Spannung Uₘₐₓ gehörende optimale Anzahl der Durchschläge pro Zeiteinheit nₒₚₜ bestimmt. Die optimale Anzahl von Durchschlägen pro Zeiteinheit nₒₚₜ wird daher in einer Art Kennlinie bestimmt, wobei zur Aufnahme der Kennlinie der Spannungsverlauf auf verschiedene, vorgegebene Anzahlen von Durchschlägen pro Zeiteinheit nₛ geregelt wird.

Im Unterschied zu allen anderen bekannten Verfahren wird bei dem erfindungsgemäßen Verfahren ein Regelverfahren in mehreren Schritten zur Ermittlung der optimalen Anzahl von Durchschlägen nₒₚₜ benutzt. Dasselbe Regelungsverfahren kann in der zweiten Stufe auch zur Regelung auf die optimale Anzahl von Durchschlägen pro Zeiteinheit nₒₚₜ eingesetzt werden. Dies führt zu einer Vereinfachung des Betriebes des elektrostatischen Abscheiders im Vergleich zu dem aus der DE-C 42 20 658 bekannten Verfahren, bei dem Vorschriften zur Bestimmung der optimalen Anzahl von Durchschlägen nₒₚₜ, Vorschriften zur Bestimmung der Zielspannung und Vorschriften zum Führen der Spannung an der Durchschlaggrenze benötigt werden.

An die Meßwerte, die jeweilige, mittlere Spannung U in Abhängigkeit von der tatsächlich gemessenen Anzahl von Durchschlägen pro Zeiteinheit nᵢ gemäß Anspruch 2 ein Polynom zweiten Grades anzupassen, um daraus die zur maximalen mittleren Spannung Uₘₐₓ gehörende optimale Anzahl der Durchschläge pro Zeiteinheit nₒₚₜ zu berechnen, ist eine einfach Methode nₒₚₜ zu bestimmen.

Gemäß Anspruch 3 kann eine erneute Kurvenanpassung durchgeführt werden, falls die an die Meßwerte angepaßte Kurve kein Maximum aufweist. Dabei wird die Zahl der Meßwerte verringert, indem die Meßwerte mit den größten Abweichungen, gestrichen werden. Damit können zufällige Meßfehler eliminiert oder aber die Auswirkung von großen schnellen Schwankungen verringert werden. Eine zweite Möglichkeit die Zahl der Meßwerte zu verringern ist, die ersten Meßwerte wegzulassen. Dies ist bei Änderung des Betriebszustandes während der Ermittlungsstufe von Vorteil.

Falls die an die Meßwerte angepaßte Kurve kein Maximum aufweist, können gemäß Anspruch 4 die ersten Ermittlungsschritte wiederholt werden. Dies ist bei starken Änderungen des Betriebszustandes während der Ermittlungsstufe von Vorteil.

Die Anzahl der Ermittlungsschritte Z kann gemäß Anspruch 5 zwischen 3 und 15 variiert werden. 4, gelegentlich auch nur 3, Ermittlungsschritte und damit Meßpunkte benötigt man mindestens um eine Kurvenanpassung durchzuführen. Eine hohe Anzahl von Meßpunkten kann zu einer sehr genauen Ermittlung der optimalen Anzahl von Durchschlägen pro Zeiteinheit nₒₚₜ führen. Sie sollte bevorzugt bei Betriebszuständen mit einer hohen optimalen Anzahl von Durchschlägen pro Zeiteinheit nₒₚₜ verwendet werden.

Gemäß Anspruch 6 können die Sollwerte der Anzahl von Durchschlägen nₛ von einem zum nächsten Ermittlungsschritt um Δ nₛ 3 bis 15, z.B. um 5 oder um 10, Durchschläge pro Zeiteinheit geändert werden.

Es ist möglich, die Sollwerte nₛ der Ermittlungsschritte in Abhängigkeit von der zuletzt ermittelten optimalen Anzahl von Durchschlägen pro Zeiteinheit nₒₚₜ zu bestimmen, beispielsweise indem etwa die Hälfte der Sollwerte kleiner und die restlichen Sollwerte größer als nₒₚₜ gewählt werden. Wenn der vorherige Wert nₒₚₜ relativ hoch oder relativ niedrig ist, kann dies zu zur Kurvenanpassung ungünstigen Meßpunkten führen. Daher ist es vorteilhaft gemäß Anspruch 7 die Sollwerte nₛ der Ermittlungsschritte fest vorzugeben.

Vorteilhaft ist es weiter, die erste Stufe, die Ermittlungsstufe, gemäß Anspruch 8 in einer Ermittlungszeit T von 3 bis 30 Minuten durchzuführen. Kleinere Ermittlungszeiten, d. h. wenige Minuten, sind bei verhältnismäßig hohen optimalen Anzahlen von Durchschlägen pro Zeiteinheit nₒₚₜ und schnellen Änderungen der Betriebsbedingungen von Vorteil. Längere Ermittlungszeiten können bei relativ konstanten Betriebsbedingungen zu einer sehr genauen Ermittlung der optimalen Anzahl von Durchschlägen pro Zeiteinheit nₒₚₜ eingesetzt werden.

Gemäß Anspruch 9 wird die Spannung in den Regelintervallen der Ermittlungsschritte und der Regelstufe folgendermaßen geführt: Die Spannung wird nach einen Durchschlag abgesenkt, ggf. wird eine Pulssperrzeit τ abgewartet, anschließend wird die Spannung mit einer Schnellhochlaufgeschwindigkeit vₛ bis auf einen Spannungswert Uₛ, der um die Absenkung U_{A} kleiner ist als die Durchschlagsspannung U_{D}, und mit einer Langsamhochlaufgeschwindigkeit v₁ bis zum erneuten Durchschlag erhöht. Der Spannungsverlauf wird geregelt, indem nach jedem Regelintervall der Istwert einer von der vorgegebenen Anzahl von Durchschlägen pro Zeiteinheit nₛ oder nₒₚₜ abgeleiteten Regelgröße mit seinem Sollwert verglichen wird und entsprechend der Abweichung eine oder mehrere der möglichen Stellgrößen: Pulssperrzeit τ, Schnellhochlaufgeschwindigkeit vₛ, Absenkung U_{A}, Langsamhochlaufgeschwindigkeit vₗ, Strombegrenzung iₘₐₓ oder Spannungsbegrenzung uₘₐₓ verändert wird. Die Veränderung der Stellgrößen erfolgt nach allgemein bekannten Regelalgorithmen oder nach Regeln der Fuzzy-Technik. Auch bei diesem Verfahren wird die Durchschlagsspannung U_{D} benötigt um aus der Absenkung U_{A} den Spannungswert Uₛ, auf den die Spannung nach einem Durchschlag mit der Schnellhochlaufgeschwindigkeit vₛ erhöht wird, zu ermitteln. Es handelt sich jedoch bei der Spannungsabsenkung U_{A} nur um einen von mehreren, oben als Stellgrößen aufgezahlten Parametern des Spannungsverlaufes. Im Gegensatz zu dem aus der DE-C 42 20 658 bekannten Verfahren wird die Spannung nach Erreichen des Spannungswerts Uₛ mit einer Langsamhochlaufgeschwindigkeit vₗ bis zum erneuten Durchschlag erhöht. Dies ermoglicht ein Führen der Spannung näher an der Durchschlaggrenze als in dem bekannten Verfahren.

Gemäß Anspruch 10 kann die innerhalb einer vorgegebenen Zeit t gemessene Anzahl N von Durchschlägen als Regelgröße verwendet werden. Dabei wird die Zeit eines Regelintervalles t vorgegeben und aus der vorgegebenen Anzahl von Durchschlägen pro Zeiteinheit nₛ oder nₒₚₜ der Sollwert der Anzahl der Durchschläge N berechnet. Die Anzahl der gemessenen Durchschläge N in einem Regelintervall der Zeit t wird mit diesem Sollwert verglichen. Eine fest vorgegebene Zeit t in einem Regelintervall hat den Vorteil, daß die Auswirkung von Fehlmessungen z.B. durch Folgedurchschläge, verhältnismäßig gering ist.

Gemäß Anspruch 11 kann auch die zwischen zwei Durchschlägen gemessene Zeit Δ t als Regelgröße verwendet werden. Der Sollwert ergibt sich direkt aus der vorgegebenen Anzahl von Durchschlägen pro Zeiteinheit nₛ oder nₒₚₜ. Vorteil dieser Regelgröße ist, daß die Regelung verhältnismäßig schnell auf Änderungen reagieren kann.

Bei einer einfachen Form der Regelung wird gemäß Anspruch 12 die Langsamhochlaufgeschwindigkeit vₗ als Stellgröße verwendet.

Zur Verfeinerung der Regelung kann gemäß Anspruch 13 zusätzlich die Spannungsabsenkung U_{A} als Stellgröße verwendet werden. Dabei sollte jedoch das Verhältnis aus Langsamhochlaufgeschwindigkeit vₗ und Spannungsabsenkung U_{A} bei Änderung der Spannungsabsenkung einen Bereich von 0,5 bis 12 (kV/min 1/kV) nicht überschreiten.

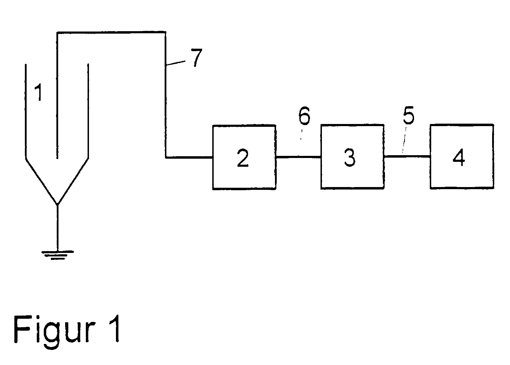

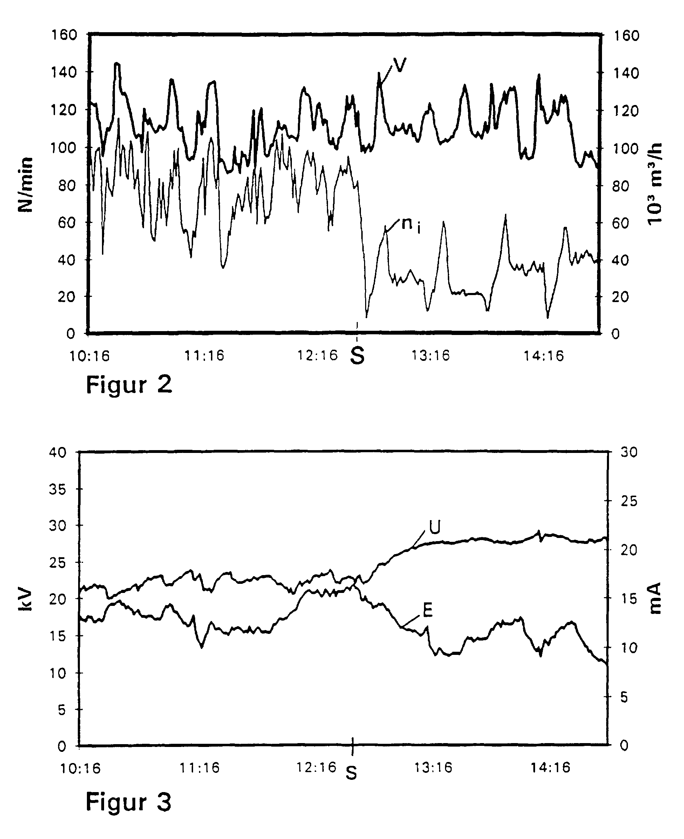

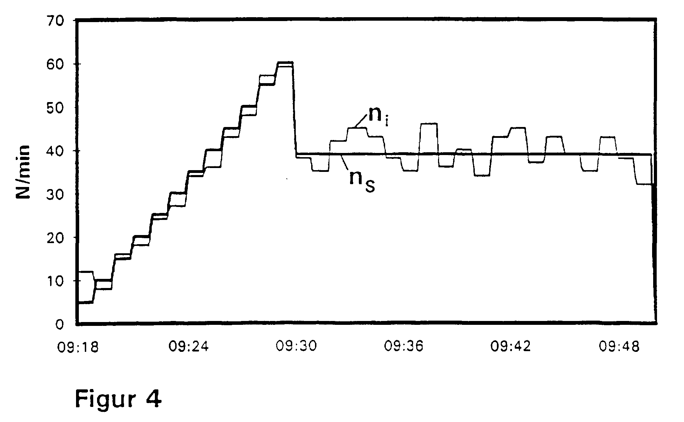

Die Erfindung wird anhand eines Beispiels mit Hilfe der Zeichnung weiter erläutert. Figur 1 zeigt die schematische Darstellung eines E-Filters mit Vorrichtungen zum Betrieb des E-Filters. Figur 2 zeigt den Verlauf der Anzahl der Durchschläge pro Zeiteinheit nᵢ (Anzahl N pro Minute) bei Einsetzen des erfindungsgemäßen Verfahrens am Punkt S und den des Volumenstroms V (10³m³/h). In Figur 3 sind die dazugehörigen Spannungsmittelwerte U (kV) sowie die Extinktion E (gemessen in mA) dargestellt. In Figur 4 ist ein zeitlicher Ausschnitt des in den Figuren 2 und 3 dargestellten Beispiels zu sehen, wobei die gemessene Anzahl der Durchschläge pro Zeiteinheit nᵢ sowie ihre Sollwerte nₛ dargestellt sind.

Neben dem E-Filter 1 sind in Figur 1 eine Vorrichtung zur Spannungsversorgung 2 des E-Filters 1, eine Steuervorrichtung 3 und eine Regelvorrichtung 4 dargestellt. Die Regelvorrichtung, beispielsweise ein PC ausgerüstet mit üblichen Regelalgorithmen und/oder Fuzzy-Prozessoren, ist über eine Leitung 5 mit der Steuervorrichtung 3 verbunden. Es können handelsübliche Steuervorrichtungen eingesetzt werden. Die Steuervorrichtung sollte jedoch einen Spannungsverlauf nach einem Durchschlag mit ggf. einer Pulssperrzeit, einer Schnellhochlaufgeschwindigkeit, einer Absenkung, einer Langsamhochlaufgeschwindigkeit und ggf. einer Strombegrenzung und einer Spannungsbegrenzung ermöglichen. Die gerade genannten Parameter sollten einzeln einstellbar sein. Die Steuervorrichtung 3 ist über eine Leitung 6 mit der Vorrichtung zur Spannungsversorgung 2 verbunden und diese wiederum über eine Leitung 7 mit den Sprühelektroden des E-Filters 1.

Bei dem erfindungsgemäßen Verfahren werden Zyklen aus einer ersten Stufe, in der eine optimale Anzahl von Durchschlägen pro Zeiteinheit nₒₚₜ ermittelt wird, und einer zweiten Stufe, in der die Spannung auf diesen Wert nₒₚₜ geregelt wird, ständig wiederholt. Die Dauer einer Ermittlungsstufe T_{E} kann 3 bis 30 Minuten betragen. Die Gesamtzeit eines Zyklus kann zwischen 5 Minuten und bis zu 24 Stunden gewählt werden. Geringere Zykluszeiten sind bei Müllverbrennungsanlagen mit schneller wechselnden Betriebsbedingungen von Vorteil. Bei Kohlekraftwerken, die im allgemeinen recht konstante Betriebsbedingungen aufweisen, können längere Zykluszeiten von vielen Stunden, z. B. 10, 12 bis zu 24 h, gewählt werden.

Im vorliegenden Beispiel findet die Ermittlung der optimalen Anzahl von Durchschlägen pro Zeiteinheit nₒₚₜ in Z = 12 Ermittlungsschritten statt. Dabei wird der Spannungsverlauf in einem ersten Ermittlungsschritt auf nₛ = 5 Durchschläge pro Minute geregelt, in einem zweiten Ermittlungsschritt auf nₛ = 10 Durchschläge pro Minute geregelt, in einem dritten Ermittlungsschritt auf nₛ = 15 Durchschläge pro Minute usw. bis zum zwölften Ermittlungsschritt, in dem auf nₛ = 60 Durchschläge pro Minute geregelt wird. In jedem Ermittlungsschritt wird die tatsächliche Anzahl von Durchschlägen pro Zeiteinheit nᵢ und die mittlere Spannung U gemessen.

Im anschließenden Bestimmungsschritt wird aus diesem Meßwerten, d.h. aus den 12 Wertepaaren, die zur maximalen mittleren Spannung Uₘₐₓ gehörende optimale Anzahl der Durchschläge pro Zeiteinheit nₒₚₜ bestimmt. Dazu wird an die Meßwerte, nämlich die jeweilige mittlere Spannung U in Abhängigkeit von der tatsächlich gemessenen Anzahl von Durchschlägen pro Zeiteinheit nᵢ, ein Polynom zweiten Grades ax² + bx + c angepaßt. Wenn sich durch die Meßpunkte eine Kurve mit einem Maximum legen läßt, d. h. der Koeffizient a kleiner als 0 ist, wird das Maximum der Kurve, nämlich Uₘₐₓ, bestimmt und die dazugehörige Anzahl der Durchschläge pro Zeiteinheit nₒₚₜ abgelesen.

Falls die an die Meßwerte angepaßte Kurve kein Maximum aufweist, d.h. der Koeffizient a größer oder gleich 0 ist, wird eine erneute Kurvenanpassung mit einer geringeren Anzahl von Meßwerten durchgeführt. Dabei können z. B. die Meßwerte mit den größten Abweichungen oder aber die ersten Meßwerte weggelassen werden. Statt einer erneuten Kurvenanpassung, falls diese nicht zum Erfolg führt, können anschließend daran auch die ersten Ermittlungsschritte wiederholt werden und mit den Meßwerten dieser Ermittlungsschritte eine erneute Kurvenanpassung durchgeführt werden.

Figur 2 zeigt die gemessene Anzahl der Durchschläge pro Minute nᵢ in Abhängigkeit von der Zeit (abzulesen an den Uhrzeiten), wobei zum Zeitpunkt S das erfindungsgemäße Verfahren eingesetzt wird. In Figur 2 sind vier Zyklen aus je einer Ermittlungsstufe und einer Regelungsstufe dargestellt. Jeweils nach Durchlaufen der Kennlinie, d. h. nach Durchlaufen der Ermittlungsstufe aus zwölf Ermittlungsschritten und dem Bestimmungsschritt, wird in der Regelungsstufe auf eine neue optimale Anzahl von Durchschlägen pro Zeiteinheit nₒₚₜ geregelt. Der Verlauf der Spannungsmittelwerte U sowie der Extinktion E sind dazu in Figur 3 dargestellt. Mit Einschalten des erfindungsgemäßen Verfahrens ab dem Zeitpunkt S steigt der Mittelwert der Spannung U und sinkt die Extinktion E. In Figur 4, die einen der vier Zyklen vergrößert zeigt, sind die zwölf Ermittlungsschritte anhand der Sollwertkurve nₛ und der Istwertkurve nᵢ zu erkennen.

Bei diesem Beispiel sind die Sollwerte der Anzahl der Durchschläge pro Zeiteinheit ns mit den Werten 5, 10, 15, bis 60 Durchschläge pro Minute fest vorgegeben. Sie könnten auch in Abhängigkeit von dem letzten Wert für die optimale Anzahl von Durchschlägen nₒₚₜ berechnet werden. Die Anzahl von Z = 12 Meßwerten und der Abstand von Δnₛ = 5 Durchschlägen pro Minute ermöglicht auch bei recht schwankendem Volumenstrom V, wie in Figur 2 zu sehen, eine sichere Bestimmung der optimalen Anzahl von Durchschlägen pro Zeiteinheit nₒₚₜ.

Im Dauerbetrieb ist jedoch eine Ermittlungsstufe mit Z = Ermittlungsschritten, wobei sich die Anzahl der Durchschläge pro Zeiteinheit nₛ von einem zum nächsten Ermittlungsschritt um Δnₛ = 10 Durchschläge pro Minute ändert, vorzuziehen. Je nach Betriebsbedinungen kann die Anzahl der Ermittlungsschritte Z zwischen 4 und 15 variieren und die Änderung der Sollwerte von einem zum nächsten Ermittlungsschritt Δnₛ = 3 bis 15 Durchschläge pro Minute betragen.

In einem Ermittlungsschritt oder in der Regelungsstufe wird der Spannungsverlauf in mehreren Regelintervallen auf den vorgegebenen Sollwert der Anzahl der Durchschläge pro Zeiteinheit nₛ geregelt. Als Regelgröße wird in diesem Beispiel die innerhalb einer vorgebenen Zeit t gemessene Anzahl N von Durchschlägen als Regelgröße und als Stellgröße die Langsamhochlaufgeschwindigkeit vₛ verwendet.

Beträgt der Sollwert der vorgegebenen Anzahl von Durchschlägen nₛ beispielsweise 10 Durchschläge pro Minute und die vorgegebenen Zeit t eines Regelintervalles 6 Sekunden, dann beträgt der Sollwert der Anzahl von Durchschlägen Ns 1. Nach Ablauf eines Regelintervalles wird die gemessene Anzahl Nᵢ von Durchschlägen mit ihrem Sollwert Nₛ verglichen. Aus ihrer Abweichung vom Sollwert wird gemäß üblicher Regelalgorithmen oder gemäß der Regeln der Fuzzy-Technik die Verstellung der Langsamhochlaufgeschwindigkeit vₗ bestimmt. Tendenziell wird die Langsamhochlaufgeschwindigkeit vₗ verringert, wenn die gemessen Anzahl Nᵢ größer ist als ihr Sollwert Nₛ und umgekehrt.

Als Regelgröße kann auch die zwischen zwei Durchschlägen gemessene Zeit Δt verwendet werden. Ihr Sollwert wird aus dem Sollwert der Anzahl von Durchschlägen pro Zeiteinheit ermittelt. Beispielsweise beträgt bei einem Sollwert nₛ von 10 Durchschlägen pro Minuten der Sollwert Δ tₛ 6 Sekunden.

In den Regelintervallen der Ermittlungsschritte und der Regelstufe wird die Spannung folgendermaßen geführt: Nach einem Durchschlag wird die Spannung abgesenkt, ggf. wird eine Pulssperrzeit τ abgewartet, anschließend wird die Spannung mit einer Schnellhochlaufgeschwindigkeit vₛ bis auf einen Spannungswert Uₛ, der um die Absenkung U_{A} kleiner ist als die Durchschlagspannung U_{D}, und danach mit einer Langsamhochlaufgeschwindigkeit vₗ bis zum erneuten Durchschlag erhöht.

Gleichzeitig zur Langsamhochlaufgeschwindigkeit vₗ kann auch die Spannungsabsenkung U_{A} als Stellgröße verwendet werden. Die Änderungen der Spannungsabsenkung U_{A} werden jedoch so vorgenommen, daß das Verhältnis aus Langsamhochlaufgeschwindigkeit v_{I} und Spannungsabsenkung UA den Bereich von 0,5 bis 12 (kV/min * 1/kV) nicht überschreitet.

## Patentansprüche

1. Verfahren zum Betrieb eines elektrostatischen Abscheiders, bei dem die Spannung ausgehend von einer optimalen Anzahl von Durchschlägen nₒₚₜ an der Durchschlaggrenze geführt wird, **dadurch gekennzeichnet, daß** in einer ersten Stufe eine optimale Anzahl von Durchschlägen pro Zeiteinheit nₒₚₜ ermittelt wird, indem der Spannungsverlauf in aufeinander folgenden Ermittlungsschritten auf verschiedene, vorgegebene Anzahlen von Durchschlägen pro Zeiteinheit nₛ geregelt wird, wobei jeweils die tatsächliche Anzahl von Durchschlägen pro Zeiteinheit nᵢ und die mittlere Spannung U gemessen wird, und in einem anschließenden Bestimmungsschritt aus diesen Meßwerten die zur maximalen mittleren Spannung Uₘₐₓ gehörende optimale Anzahl der Durchschläge pro Zeiteinheit nₒₚₜ bestimmt wird, in einer zweiten Stufe die Spannung auf diese optimale Anzahl von Durchschlägen pro Zeiteinheit nₒₚₜ geregelt wird und Zyklen aus erster und zweiter Stufe wiederholt werden und daß im Bestimmungsschritt der ersten Stufe an die Meßpunkte ein Polynom zweiten Grades angepaßt wird und die zur maximalen mittleren Spannung Uₘₐₓ gehörende optimale Anzahl der Durchschläge pro Zeiteinheit nₒₚₜ berechnet wird.

2. Verfahren nach Anspruch 1, **dadurch gekennzeichnet, daß**, falls die an die Meßwerte angepaßte Kurve kein Maximum aufweist, eine erneute Kurvenanpassung an eine verringerte Zahl von Meßwerten durchgeführt wird.

3. Verfahren nach Anspruch 1, **dadurch gekennzeichnet, daß**, falls die an die Meßwerte angepaßte Kurve kein Maximum aufweist, die ersten Ermittlungsschritte wiederholt werden.

4. Verfahren nach einem der Ansprüche 1 bis 3, **dadurch gekennzeichnet, daß** Z = 3 bis 15 Ermittlungsschritte durchgeführt werden.

5. Verfahren nach einem der Ansprüche 1 bis 4, **dadurch gekennzeichnet, daß** die Sollwerte der Anzahl der Durchschläge pro Zeiteinheit nₛ von einem zum nächsten Ermittlungsschritt um Δnₛ = 3 bis 15 Durchschläge pro Minute geändert werden.

6. Verfahren nach einem der Ansprüche 1 bis 5, **dadurch gekennzeichnet, daß** die Sollwerte der Anzahl der Durchschläge pro Zeiteinheit nₛ der Ermittlungsschritte fest vorgegeben sind.

7. Verfahren nach einem der Ansprüche 1 bis 6, **dadurch gekennzeichnet, daß** die erste Stufe in einer Ermittlungszeit von T_{E} 3 bis 30 Minuten durchgeführt wird.

8. Verfahren nach einem der Ansprüche 1 bis 6, **dadurch gekennzeichnet, daß** der Spannungverlauf in den Ermittlungsschritten und in der Regelstufe auf eine vorgegebene Anzahl von Durchschlagen nₛ oder nₒₚₜ geregelt wird, indem die Spannung nach einem Durchschlag abgesenkt wird, gegebenenfalls eine Pulssperrzeit τ abgewartet wird, die Spannung mit einer Schnellhochlaufgeschwindigkeit vₛ bis auf einen Spannungswert Uₛ, der um die Absenkung U_{A} kleiner ist als die Durchschlagspannung U_{D}, und mit einer Langsarnhochlaufgeschwindigkeit vₗ bis zum erneuten Durchschlag erhöht wird, wobei eine von der vorgegebenen Anzahl von Durchschlägen nₛ oder nₒₚₜ abgeleitete Größe als Regelgröße und eine oder mehrere der folgenden Parameter: Pulssperrzeit τ, Schnellhochlaufgeschwindigkeit vₛ, Absenkung U_{A}, Langsamhochlaufgeschwindigkeit vₗ, Strombegrenzung iₘₐₓ oder Spannungsbegrenzung Uₘₐₓ als Stellgrößen verwendet werden.

9. Verfahren nach Anspruch 8, **dadurch gekennzeichnet, daß** die innerhalb einer vorgegebenen Zeit t gemessene Anzahl N von Durchschlägen als Regelgröße verwendet wird.

10. Verfahren nach Anspruch 8, **dadurch gekennzeichnet, daß** die zwischen zwei Durchschlägen gemessene Zeit Δt als Regelgröße verwendet wird.

11. Verfahren nach einem der Ansprüche 8 bis 10, **dadurch gekennzeichnet, daß** ausschließlich die Langsamhochlaufgeschwindigkeit vₗ als Stellgröße verwendet wird.

12. Verfahren nach einem der Ansprüche 8 bis 10, **dadurch gekennzeichnet, daß** sowohl die Langsamhochlaufgeschwindigkeit vₗ als auch die Spannungsabsenkung U_{A} als Stellgrößen verwendet werden, wobei bei der Änderung der Spannungsabsenkung U_{A} das Verhältnis aus Langsamhochlaufgeschwindigkeit vₗ und Spannungsabsenkung U_{A} einen Bereich von 0,5 bis 12 (kV/min * 1/kV) nicht überschritten wird.

## Claims

1. Method of operating an electrostatic separator in which the voltage is taken to the breakdown limit starting from an optimal number of disruptive breakdowns nₒₚₜ, **characterised in that** in a first stage an optimal number of disruptive breakdowns per unit time nₒₚₜ is ascertained **in that** the voltage course in successive ascertaining steps is regulated to different, predetermined numbers of disruptive breakdowns per unit time nₛ, wherein on each occasion the actual number of disruptive breakdowns per unit time nᵢ and the mean voltage U are measured, and in a subsequent determining step the optimal number, which belongs to the maximum mean voltage Uₘₐₓ, of the disruptive breakdowns per unit time nₒₚₜ is determined from these measurement values, in a second stage the voltage is regulated to this optimal number of disruptive breakdowns per unit time nₒₚₜ and cycles of first and second stages are repeated and that in the determining step of the first stage a polynomial of second degree is adapted to the measuring point and the optimal number, which belongs to the maximum mean voltage Uₘₐₓ, of the disruptive breakdowns per unit time nₒₚₜ is calculated.

2. Method according to claim 1, **characterised in that** in case the curve adapted to the measurement values has no maximum a renewed curve adaptation to a reduced number of measurement values is carried out.

3. Method according to claim 1, **characterised in that** in case the curve adapted to the measurement values has no maximum the first ascertaining steps are repeated.

4. Method according to one of claims 1 to 3, **characterised in that** Z = 3 to 15 ascertaining steps are carried out.

5. Method according to one of claims 1 to 4, **characterised in that** the target values of the number of disruptive breakdowns per unit time nₛ are varied from one ascertaining step to the next by Δnₛ = 3 to 15 disruptive breakdowns per minute.

6. Method according to one of claims 1 to 5, **characterised in that** the target values of the number of disruptive breakdowns per unit time nₛ of the ascertaining steps are fixedly preset.

7. Method according to one of claims 1 to 6, **characterised in that** the first stage is undertaken in an ascertaining time of T_{E} of 3 to 30 minutes.

8. Method according to one of claims 1 to 6, **characterised in that** the voltage course in the ascertaining steps and in the regulating stage is regulated to a predetermined number of disruptive breakdowns nₛ or nₒₚₜ **in that** the voltage is reduced after a disruptive breakdown, in a given case a pulse blocking time τ is waited out, the voltage at a fast run-up speed vₛ is increased to a voltage value Uₛ which is smaller by the reduction U_{A} than the disruptive breakdown voltage U_{D} and at a slow run-up speed vₗ is increased to the renewed disruptive breakdown, wherein a magnitude derived from the preset number of disruptive breakdowns nₛ or nₒₚₜ is used as a regulating magnitude and one or more of the parameters of pulse blocking time τ, fast run-up speed vₛ, reduction U_{A}, slow run-up speed vₗ, current limit iₘₐₓ or voltage limit Uₘₐₓ is or are used as setting magnitudes.

9. Method according to claim 8, **characterised in that** the number N, which is measured within a predetermined time t, of disruptive breakdowns is used as regulating magnitude.

10. Method according to claim 8, **characterised in that** the time Δt measured between two disruptive breakdowns is used as regulating magnitude.

11. Method according to one of claims 8 to 10. **characterised in that** the slow run-up speed vₗ exclusively is used as setting magnitude.

12. Method according to one of claims 8 to 10, **characterised in that** not only the slow run-up speed vₗ, but also the voltage reduction U_{A} are used as setting magnitudes, wherein in the case of change in the voltage reduction U_{A} the ratio of slow run-up speed vₗ and voltage reduction U_{A} does not exceed a range of 0.5 to 12 (kV/min * 1/kV).

## Revendications

1. Procédé de fonctionnement d'un séparateur électrostatique, selon lequel la tension est amenée à la limite de claquage à partir d'un nombre optimal de décharges disruptives nₒₚₜ, **caractérisé en ce qu'**un nombre optimal de décharges disruptives par unité de temps nₒₚₜ est recherché dans un premier stade, l'allure de tension étant réglée dans des phases de recherche successives à différents nombres prédéfinis de décharges disruptives par unité de temps nₛ, le nombre effectif de décharges disruptives par unité de temps nᵢ et la tension moyenne U étant à chaque fois mesurés, et le nombre optimal de décharges disruptives par unité de temps nₒₚₜ, correspondant à la tension moyenne maximale Uₘₐₓ, étant défini dans une phase de définition suivante à partir de ces valeurs de mesure, la tension est réglée dans un second stade sur ce nombre optimal de décharges disruptives par unité de temps nₒₚₜ et des cycles du premier et du second stade étant réitérés, et qu'un polynôme du deuxième degré est adapté aux points de mesure dans la phase de définition du premier stade, et le nombre optimal de décharges disruptives par unité de temps nₒₚₜ, correspondant à la tension moyenne maximale Uₘₐₓ, est calculé.

2. Procédé suivant la revendication 1, **caractérisé en ce que**, si la courbe adaptée aux valeurs de mesure ne présente aucun maximum, une nouvelle adaptation de courbe à un nombre réduit de valeurs de mesures est réalisée.

3. Procédé suivant la revendication 1, **caractérisé en ce que**, si la courbe adaptée aux valeurs de mesure ne présente aucun maximum, les premières phases de recherche sont réitérées.

4. Procédé suivant l'une des revendications 1 à 3, **caractérisé en ce que** Z = 3 à 15 phases de recherche sont réalisées.

5. Procédé suivant l'une des revendications 1 à 4, **caractérisé en ce que** les valeurs de consigne du nombre de décharges disruptives par unité de temps nₛ sont modifiées de Δnₛ = 3 à 15 décharges disruptives par minute d'une phase de recherche à la phase suivante.

6. Procédé suivant l'une des revendications 1 à 5, **caractérisé en ce que** les valeurs de consigne du nombre de décharges disruptives par unité de temps nₛ des phases de recherche sont fixement prédéfinies.

7. Procédé suivant l'une des revendications 1 à 6, **carac-térisé en ce que** le premier stade est réalisé en un temps de recherche T_{E} de 3 à 30 minutes.

8. Procédé suivant l'une des revendications 1 à 6, **caractérisé en ce que** l'allure de tension est réglée sur un nombre prédéfini de décharges disruptives nₛ ou nₒₚₜ dans les phases de recherche et dans le stade de régulation, la tension étant abaissée après une décharge disruptive, un temps d'arrêt d'impulsions τ étant éventuellement attendu, la tension étant élevée à une vitesse d'accélération rapide vₛ jusqu'à une valeur de tension U_{S}, inférieure de l'abaissement U_{A} à la tension disruptive U_{D}, et à une vitesse d'accélération lente vₗ jusqu'à répétition de la décharge disruptive, une grandeur dérivée du nombre prédéfini de décharges disruptives nₛ ou nₒₚₜ étant alors utilisée comme grandeur réglée, et l'un ou plusieurs des paramètres suivants : temps d'arrêt d'impulsions τ, vitesse d'accélération rapide vₛ, abaissement U_{A}, vitesse d'accélération lente vₗ, limitation de courant iₘₐₓ ou limitation de tension Uₘₐₓ, étant utilisés comme grandeurs de réglage.

9. Procédé suivant la revendication 8, **caractérisé en ce que** le nombre N de décharges disruptives mesuré à l'intérieur d'un temps t prédéfini est utilisé comme grandeur réglée.

10. Procédé suivant la revendication 8, **caractérisé en ce que** le temps Δt mesuré entre deux décharges disruptives est utilisé comme grandeur réglée.

11. Procédé suivant l'une des revendications 8 à 10, **caractérisé en ce que** la vitesse d'accélération lente vₗ est exclusivement utilisée comme variable réglante.

12. Procédé suivant l'une des revendications 8 à 10, **caractérisé en ce qu'**aussi bien la vitesse d'accélération lente vₗ que l'abaissement de tension U_{A} sont utilisés comme variables réglantes, le rapport de la vitesse d'accélération lente vₗ et de l'abaissement de tension U_{A} ne devant pas dépasser une plage de 0,5 à 12 (kV/min * 1/kV) lors de la modification de l'abaissement de tension U_{A}.
